(19) Europäisches Patentamt
European Patent Office
Office européen des brevets

(11) EP 2 439 252 A1

(12) # EUROPEAN PATENT APPLICATION
published in accordance with Art. 153(4) EPC

(43) Date of publication:
**11.04.2012 Bulletin 2012/15**

(21) Application number: **10783368.3**

(22) Date of filing: **01.06.2010**

(51) Int Cl.:
***C09K 11/85*** *(2006.01)* ***C09K 11/00*** *(2006.01)*
***G01T 1/20*** *(2006.01)*

(86) International application number:
**PCT/JP2010/059263**

(87) International publication number:
**WO 2010/140585 (09.12.2010 Gazette 2010/49)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **03.06.2009 JP 2009134323**

(71) Applicants:
- **Tokuyama Corporation**
**Shunan-shi, Yamaguchi-ken 745-8648 (JP)**
- **Tohoku University**
**Aoba-ku**
**Sendai-shi**
**Miyagi 980-8577 (JP)**

(72) Inventors:
- **FUKUDA, Kentaro**
**Shunan-shi**
**Yamaguchi 745-8648 (JP)**
- **ISHIZU, Sumito**
**Shunan-shi**
**Yamaguchi 745-8648 (JP)**
- **KAWAGUCHI, Noriaki**
**Shunan-shi**
**Yamaguchi 745-8648 (JP)**
- **SUYAMA, Toshihisa**
**Shunan-shi**
**Yamaguchi 745-8648 (JP)**
- **YOSHIKAWA, Akira**
**Sendai-shi**
**Miyagi 980-8577 (JP)**
- **YANAGIDA, Takayuki**
**Sendai-shi**
**Miyagi 980-8577 (JP)**
- **YOKOTA, Yui**
**Sendai-shi**
**Miyagi 980-8577 (JP)**

(74) Representative: **Duckworth, Timothy John**
**J.A. Kemp & Co.**
**14 South Square**
**Gray's Inn**
**London WC1R 5JJ (GB)**

(54) **SCINTILLATOR**

(57) [Problems to be Solved] The present invention aims to provide a scintillator which can detect photons of high energy, such as hard X-rays or γ-rays, with high sensitivity.

[Means to Solve the Problems] A scintillator comprises lithium lutetium fluoride containing neodymiumas a luminescence center, the lithium lutetium fluoride being represented by the chemical formula $LiLu_{1-x}Nd_xF_4$ where x is in the range of 0.00001 to 0.2, preferably, 0.0001 to 0.05. Preferably, the scintillator comprises a single crystal of the lithium lutetium fluoride containing neodymium.

EP 2 439 252 A1

## Description

Technical Field:

This invention relates to a novel scintillator comprising a specific inorganic compound. The scintillator can be used as a radiation sensing or detecting element of a radiation detector, and can be used preferably in medical fields such as positron emission tomography and X-ray CT, industrial fields such as various nondestructive tests, and security fields such as radiation monitors and inspection of personal belongings.

Background Art:

Radiation application technologies, namely, technologies utilizing radiation, cover a wide range of fields, including medical fields such as positron emission tomography and X-ray CT, industrial fields such as various nondestructive tests, and security fields such as radiation monitors and inspectionof personal belongings, and aremakingmarkedprogress even now.
Radiation detectors are constituent technologies occupying an important position in the radiation application technologies. With the progress of the radiation application technologies, the radiation detectors are required to achieve higher performance in connection with detection sensitivity, position resolution on the incident position of radiation, or counting rate characteristic. As the radiation application technologies become widespread, cost reduction and an increased sensitive area are also demanded of the radiation detectors.
To fulfill the above demands made on the radiation detectors, the present inventors have already proposed a novel radiation detector which is a combination of a scintillator having high stopping power against photons of high energy, and a gas multiplication type detector which shows low detection sensitivity to photons of high energy, but is excellent in position resolution, and is easily downsized and easily reduced in cost (see Patent Document 1).
The radiation detector is a radiation detector using neodymium-containing lanthanum fluoride or neodymium-containing lithiumbarium fluoride as a scintillator. Since this radiation detector can convert incident radiation into vacuum ultraviolet rays with a short wavelength, it can efficiently perform the ionization of a gas. To enhance the performance, such as detection sensitivity, of the radiation detector, however, it has been necessary to improve light emission intensity of the scintillator.
On the other hand, there have been few studies of a scintillator emitting light in the vacuum ultraviolet region with a wavelength of 200 nm or less which is useful as the scintillator used in the above radiation detector. Therefore, it has been extremely difficult to find out a scintillator excellent in light emission intensity.
In connection with neodymium-containing lithium lutetium fluoride used as the scintillator of the present invention, its luminescence properties or light emission characteristics when irradiated with photons of low energy have been reported (see Non-Patent Document 1). However, there has been no report of the light emission characteristics when irradiated with photons of high energy. Thus, its usefulness as a scintillator has been unknown.

Prior Art Documents:

Patent Documents:

Patent Document 1: JP-A-2008-202977

Non-Patent Documents:

Non-Patent Document 1: Semashko, V.V. et al., "Regarding the possibilities of upconversion UV and VUV lasers based on 5d-4f transitions of rare-earth ions in wide-bandgap dielectric crystals" Proceedings of SPIE-The International Society for Optical Engineering, 4061, 306-316 (2000).
Non-Patent Document 2: P. Schotanus, et al., Nuclear Instruments and Methods in Physics Research, A272, 913-916 (1988).

Summary of the Invention:

Problems to be solved by the invention:

It is an object of the present invention to provide a scintillator which can detect photons of high energy, such as hard X-rays or γ-rays, with high sensitivity.

Means for solving the problems:

The present inventors have conducted various studies on a scintillator which is useful for the aforementioned radiation detector composed of a combination of a scintillator and a gas multiplication detector, and which emits light in the vacuum ultraviolet region with a wavelength of 200 nm or less.
As a result, they have found that a scintillator having a high efficiency of detecting high energy photons and having excellent light emission intensity is obtained by incorporating neodymium, as a luminescence center element, into lithium lutetium fluoride. This finding has led them to accomplish the present invention.
That is, according to the present invention, there is provided a scintillator comprising neodymium-containing lithium lutetium fluoride which is represented by the following chemical formula

$$LiLu_{1-x}Nd_xF_4$$

where x denotes a numerical value of 0.00001 to 0.2.
In the scintillator, it is preferred

1) that the neodymium-containing lithium lutetium fluoride be a single crystal, and
2) that the scintillator be a scintillator for high energy photons.

Effects of the invention:

According to the present invention, a scintillator capable of detecting high energy photons, such as hard X-rays or γ-rays, with high sensitivity is provided. The scintillator of the present invention has a high detection efficiency for high energy photons and having excellent light emission intensity. Since its light emission wavelength is about 180 to 190 nm, moreover, its ionization of a gas in a gas multiplication detector is carried out efficiently. Thus, a radiation detector composed of the scintillator and the gas multiplication detector in combination is improved in performance such as detection sensitivity, and can be used preferably in fields such as medicine, industries, and security.

Brief Description of the Drawings:

[Fig. 1] shows light emission spectra representing the luminescence properties of scintillators according to the present invention.
[Fig. 2] is a schematic view of a production apparatus adopting a micro-pulling-down method.
[Fig. 3] shows the pulse height distribution spectrum of the scintillator of Example 1 when irradiated with α-rays.
[Fig. 4] shows the pulse height distribution spectrum of the scintillator of Example 2 when irradiated with α-rays.
[Fig. 5] shows the pulse height distribution spectrum of the scintillator of Example 3 when irradiated with α-rays.
[Fig. 6] shows the pulse height distribution spectrum of the scintillator of Example 4 when irradiated with α-rays.
[Fig. 7] is a schematic view of a radiation detector composed of the scintillator and a gas multiplication detector.

Mode for Carrying Out the Invention:

The scintillator of the present invention is represented by the chemical formula $LiLu_{1-x}Nd_xF_4$ where x denotes a numerical value in the range of 0.00001 to 0.2. This scintillator is characterized by being formed from lithium lutetium fluoride containing neodymium (will hereinafter be referred to as Nd-containing lithium lutetium fluoride).
In the Nd-containing lithium lutetium fluoride, neodymium is a luminescence center element, and has been substituted for part of lutetium of lithium lutetium fluoride and thereby incorporated into the lithium lutetium fluoride.
The letter x represents the content of neodymium. If x is less than 0.00001, light emission is so feeble that the resulting product cannot withstand use as a scintillator. If x exceeds 0.2, a heterogeneous compound such as neodymium fluoride ($NdF_3$), for example, tends to enter, lowering light emission characteristics. The x is preferably set to be in the range of 0.0001 to 0.05. By setting the x at 0.0001 or more, the probability for light emission via neodymium, the luminescence center element, is increased, so that high intensity of light emission can be obtained. By setting the x at 0.05 or less, attenuation of light emission due to concentration quenching can be avoided.

A scintillator comprising the Nd-containing lithium lutetium fluoride exhibits light emission based on the 5d-4f transition of neodymium upon the incidence of radiation. By having a photodetector at a subsequent stage detect such light emission, therefore, the scintillator makes it possible to detect the radiation.

The scintillator has a light emission wavelength of about 180 to 190 nm, and allows a gas multiplication detector to ionize a gas efficiently. Thus, the scintillator in combination with the above-mentioned gas multiplication detector can constitute a radiation detector. Furthermore, the scintillator shows very high light emission intensity as compared with a known scintillator which emits light in the vacuum ultraviolet region at a light emission wavelength of 200 nm or less, such as a scintillator comprising lanthanum fluoride which contains neodymium.

The scintillator of the present invention comprising the Nd-containing lithium lutetium fluoride has an effective atomic number of 63 to 64 and a density of about 6.0 to 6.2 g/ml, both parameters being extremely high. Thus, the scintillator shows excellent stopping power against photons of high energy, and can detect high energy photons efficiently.

In the present invention, the effective atomic number is an indicator defined by the following equation:

$$\text{Effective atomic number} = (\Sigma WiZi^4)^{1/4}$$

where Wi and Zi represent, respectively, the mass fraction and atomic number of the i-th element of the elements constituting the scintillator.

The form of the Nd-containing lithium lutetium fluoride in the present invention is not limited, and any form such as a crystal or glass can be used. This compound is generally produced as a crystal, and this crystal can afford a particularly high intensity of light emission. The compound is also preferred, because a large crystal is industrially produced, with ease, by the melt growth method such as Czochralski method or Bridgman method to be described later.

The crystal of the Nd-containing lithium lutetium fluoride is a tetragonal crystal having a crystal structure of the lithium lutetium fluoride type and belonging to the space group I41/a. This crystal can be easily identified by a technique such as powder X-ray diffraction. Of the crystals, a single crystal is used particularly preferably. The use of the single crystal makes it possible to obtain high intensity of light emission, without causing dissipation of light at the grain boundary or loss due to non-radiative transition.

The Nd-containing lithium lutetium fluoride used in the present invention is a colorless or sightly colored transparent solid. It has satisfactory chemical stability and, when used in the usual manner, shows no deterioration of performance during a short period of time. Moreover, its mechanical strength and processability are also satisfactory, so that this compound is easy to use in a form processed into a desired shape.

In the present invention, the shape of the scintillator is not limited, but generally, the scintillator is used in a cylindrical or prismatic shape. Preferably, the scintillator has an ultraviolet emergence surface opposing a photodetector at the subsequent stage, such as a gas multiplication detector, in the radiation detector (may hereinafter be referred to simply as an ultraviolet emergence surface), and the ultraviolet emergence surface has been optically polished. By providing such an ultraviolet emergence surface, ultraviolet rays produced by the scintillator can be efficiently entered into the photodetector in the subsequent stage. The shape of the ultraviolet emergence surface is not limited, and shapes conformed to uses, such as a square shape several millimeters to several hundred millimeters square, and a circular shape of several millimeters to several hundred millimeters in diameter, can be selected as appropriate and used.

The thickness, in the direction of incidence of radiation, of the scintillator varies with the type and energy of the radiation to be detected, but generally, is several hundred micrometers to several hundred millimeters.

Application of an ultraviolet reflective coating or film, which comprises aluminum or Teflon, to the surfaces of the scintillator not opposing the photodetector of the scintillator is a preferred mode, because dissipation of ultraviolet rays produced by the scintillator can be prevented. By using an array of many of the scintillators coated with the ultraviolet reflective film, moreover, the position resolution of the radiation detector can be enhanced remarkably.

The scintillator of the present invention is not limited in the radiation to be detected, and can be used to detect any radiation such as X-rays, $\alpha$-rays, $\beta$-rays, $\gamma$-rays or neutron beam. Since the scintillator has a high effective atomic number and a high density as mentioned earlier, however, it exhibits maximum effect in detecting photons of high energy, such as hard X-rays or $\gamma$-rays, among radiations.

The method of manufacturing the Nd-containing lithium lutetium fluoride is not limited, and this compound can be manufactured by a publicly known production method. Preferably, its crystal is produced by the melt growth method such as micro-pulling-down method, Czochralski method or Bridgman method.

The value of x in the chemical formula $LiLu_{1-x}Nd_xF_4$ can be adjusted to a desired value by adjusting the amounts of lutetium and neodymium contained in the materials for production. If the Nd-containing lithium lutetium fluoride is crystalline, segregation may occur, and there may be a difference between the amounts of lutetium and neodymium contained in the raw materials and the amounts of lutetium and neodymium contained in the Nd-containing lithium lutetium fluoride. Even if such segregation occurs, however, Nd-containing lithium lutetium fluoride having a desired x value can be obtained by determining a segregation coefficient beforehand, and adjusting the amounts of lutetium and neodymium contained in the materials in consideration of this segregation coefficient.

Manufacture by the melt growth method enables Nd-containing lithium lutetium fluoride, which becomes a scintillator excellent in quality, such as light emission characteristics, to be produced. According to the micro-pulling-down method, in particular, a crystal of the desired shape can be produced directly and in a short time. According to the Czochralski method or the Bridgman method, on the other hand, a large crystal having a diameter of several inches can be produced at a low cost. In order to eliminate a crystal defect due to a deficiency in fluorine atoms or thermal strain or the like in the manufacture of the crystal by the melt growth method, annealing may be performed after the manufacture of the crystal.

A common method for producing Nd-containing lithium lutetium fluoride by the micro-pulling-down method will be described using Fig. 2. Predetermined amounts of materials are charged into a crucible 5 provided with a hole at the bottom. The shape of the hole provided in the bottom of the crucible is not limited, but is preferably a cylindrical shape having a diameter of 0.5 to 5 mm and a length of 0 to 2 mm.

As the materials, metal fluorides such as lithium fluoride (LiF), lutetium fluoride ($LuF_3$) and neodymium fluoride ($NdF_3$) are used. The purity of such materials is not limited, but is preferably 99.99% or higher. By using such a mixture of materials with high purity, the purity of the resulting Nd-containing lithium lutetium fluoride can be increased, and characteristics such as light emission intensity are improved. The materials, which are powdery or particulate, may be used, or the materials may be used after being sintered or melted and solidified beforehand.

Then, the crucible 5 charged with the above materials, an after-heater 1, a heater 2, a heat insulator 3, and a stage 4 are installed as shown in Fig. 2. Using a vacuum evacuator, the interior of a chamber 6 is evacuated to $1.0\times10^{-3}$ Pa or lower. Then, an inert gas such as high purity argon is introduced into the chamber for gas purging. The pressure within the chamber after gas purging is not limited, but is generally atmospheric pressure. By this gas purging operation, water adhering to the materials or the interior of the chamber can be removed. Decline in the characteristics of a scintillator ascribed to such water can be prevented. To avoid adverse influence due to water which cannot be removed even by the above gas purging operation, it is preferred to remove water with the use of a scavenger highly reactive with water. As such a scavenger, a solid scavenger such as zinc fluoride or a gaseous scavenger such as tetrafluoromethane can be used preferably. When the solid scavenger is used, its premixing into the materials is a preferred method. When the gaseous scavenger is used, the preferred method is to mix it with the above-mentioned inert gas and introduce the mixture into the chamber.

After the gas purging operation is performed, the materials are heated by a high frequency coil 7 and the heater 2 until they are melted. The method of heating is not limited. For example, instead of the above configuration composed of the high frequency coil and the heater, a resistance heating type carbon heater or the like can be used as appropriate.

Then, a material melt formed by melting is pulled out of the hole at the bottom of the crucible with the use of a pull-down rod 8 to start the production of Nd-containing lithium lutetium fluoride. In order to pull out the material melt from the hole at the crucible bottom smoothly, it is preferred to provide a metal wire at the front end of the pull-down rod. As the metal wire, a wire comprising a W-Re alloy and having an outer diameter of about 0.5 mm, for example, can be used preferably.

After the production of the Nd-containing lithium lutetium fluoride is started, the material melt is continuously pulled down at a constant rate, with the output of the high frequency coil being adjusted as appropriate, whereby an intended crystal of the Nd-containing lithium lutetium fluoride can be obtained. The rate of the continuous pull-down is not limited, but is preferably in the range of 0.5 to 50 mm/hr, since Nd-containing lithium lutetium fluoride free of cracks can be obtained.

The resulting Nd-containing lithium lutetium fluoride has satisfactory processability, and is easily used after being processed into a desired shape. For its processing, a cutter such as a blade saw or a wire saw, a grinder or a polishing apparatus, which is publicly known, can be used without limitation.

A scintillator comprising the Nd-containing lithium lutetium fluoride is combined with a gas multiplication detector, whereby a radiation detector can be constituted. As this gas multiplication detector, a publicly known gas multiplication detector, such as the multiwire proportional counter (MWPC) described in Non-Patent Document 2 or the like, can be used in addition to the microstrip gas chamber (MSGC) described in Patent Document 1.

Examples:

Hereinbelow, the present invention will be described in further detail by reference to its Examples, but the present invention is in no way limited by these Examples. Moreover, not all of combinations of the features described in the Examples are essential to the means for solution to problems that the present invention adopts.

Example 1

[Preparation of Nd-containing lithium lutetium fluoride]

A crystal of Nd-containing lithium lutetium fluoride was produced using a crystal production apparatus by the micro-pulling-down method shown in Fig. 2. Lithium fluoride, lutetium fluoride and neodymium fluoride, each having purity of 99.99% or more, were used as raw materials. The after-heater 1, the heater 2, the heat insulator 3, the stage 4, and the crucible 5 used were formed of high purity carbon, and the shape of the hole provided at the bottom of the crucible was a cylindrical shape with a diameter of 2.2 mm and a length of 0.5 mm.
First, the respective materials were weighed, and mixed together thoroughly. The resulting material mixture was charged into the crucible 5. The proportions of the materials in the mixture were 0.24 g of lithium fluoride, 2.1 g of lutetium fluoride, and 0.0018 g of neodymium fluoride.
Then, the crucible 5 charged with the materials was installed above the after-heater 1, and the heater 2 and the heat insulator 3 were sequentially installed around the crucible 5. Then, the interior of the chamber 6 was evacuated under vacuum to $5.0\times10^{-4}$ Pa by use of a vacuum evacuation device composed of an oil-sealed rotary vacuum pump and an oil diffusion pump. Then, a mixed gas consisting of tetrafluoromethane and argon was introduced into the chamber up to atmospheric pressure for gas purging.
A high frequency current was applied to the high frequency coil 7 to heat the materials by induction heating, thereby melting them. The W-Re wire provided at the front end of the pull-down rod 8 was inserted into the above hole provided at the bottom of the crucible 5 to pull down a melt of the materials from the hole, starting crystallization. With the output of the high frequency current being adjusted, the melt was continuously pulled down at a rate of 3 mm/hr to obtain a crystal. The crystal was a high quality single crystal having a diameter of 2.2 mm and free from cloudiness or cracking.

[Identification of Nd-containing lithium lutetium fluoride]

The crystal of Nd-containing lithium lutetium fluoride obtained by the above production was pulverized to form a powder, which was subjected to measurement by powder X-ray diffraction. The results of analysis of a diffraction pattern obtained by the powder X-ray diffraction method showed that the scintillator of the present Example consisted only of the crystal of the lithium lutetium fluoride type.
The powder formed by pulverization was press-molded to form pellets, which were subjected to measurement by fluorescent X-ray analysis. As a device for this analysis, a wavelength dispersion type fluorescent X-ray spectroscope Axios produced by PANalytical was used, and PX10 produced by PANalytical was used as a spectroscopic element.
First, in connection with pellets which were prepared by mixing predetermined amounts of lutetium fluoride and neodymium fluoride, followed by press-molding the mixture, and whose element ratio of neodymium to lutetium (hereinafter referred to as Nd/Lu) was known, wavelength dispersion type fluorescent X-ray spectroscopy was performed to plot a calibration curve. Plotting of the calibration curve used five types of pellets having Nd/Lu of 0.0001 to 0.05. Then, in connection with the pellets prepared by pulverizing the crystal of Nd-containing lithium lutetium fluoride, and press-molding the pulverized powder, fluorescent X-ray measurement was performed to plot a calibration curve, which was compared with the above-mentioned calibration curve. The Nd/Lu of the Nd-containing lithium lutetium fluoride of the present Example was found to be 0.0003.
The results of the powder X-ray diffraction measurement and the fluorescent X-ray measurement showed the Nd-containing lithium lutetium fluoride of the present Example to be represented by the chemical formula $LiLu_{1-x}Nd_xF_4$ where x is 0.0003.

[Preparation of scintillator and evaluation of light emission characteristics]

The single crystal obtained by the aforementioned production was cut to a length of 15 mm by a wire saw provided with a diamond wire, and was then ground to be processed into a rectangular parallelepiped 15 mm in length, 2 mm in width, and 1 mm in thickness. A surface of this rectangular parallelepiped, 1.5 mm long and 2mm wide, was used as an ultraviolet emergence surface, and this ultraviolet emergence surface was optically polished to obtain a scintillator.
The light emission characteristics of this scintillator when irradiated with hard X-rays were measured by the method described below, In making the measurement, the interior of the device was purged with nitrogen.
The scintillator was irradiated with hard X-rays with the use of a sealed-off X-ray tube with tungsten as a target. A tube voltage and a tube current for generating hard X-rays from the sealed-off X-ray tube were set at 60 kV and 40 mA, respectively. Ultraviolet rays appearing from the ultraviolet emergence surface of the scintillator were focused by a focusing mirror, and monochromatized by a spectroscope (KV201 extreme ultraviolet spectroscope, produced by BUNKOUKEIKI Co., Ltd.). The intensities of light emission at respective wavelengths in the range of 150 to 280 mm were recorded to obtain a spectrum of light emission produced by the scintillator. The spectrum of the resulting light emission is shown in Fig. 1.
The results of the measurements confirmed that the scintillator of the present Example emitted light extremely strongly at a wavelength of 183 nm upon incidence of hard X-rays.

A pulse height distribution spectrum, under the $\alpha$-ray irradiation, of the above scintillator was measured by the method described below.
The scintillator was bonded to a photoelectric surface of a photomultiplier tube (R8778, produced by HAMAMATSU PHOTONICS K.K.). Then, a $^{241}$Am sealed source having radioactivity of 1 kBq was installed at a position as close as possible to a surface of the crystal opposite to its surface bonded to the photoelectric surface, whereby the scintillator was irradiated with $\alpha$-rays. Then, a light shielding sheet was applied to block light entering from the outside. Then, in order to measure light emitted from the scintillator, light emission from the scintillator was converted into electrical signals via the photomultiplier tube to which a high voltage of 1300 V was applied. The electrical signals outputted from the photomultiplier tube are pulsed signals reflecting the light emission of the scintillator, and the pulse height of the pulsed signal represents the intensity of light emission.
The electrical signals outputted from the photomultiplier tube were shaped and amplified by a shaping amplifier, and entered into a multichannel pulse height analyzer to analyze them and prepare a pulse height distribution spectrum. The resulting pulse height distribution spectrum is shown in Fig. 3. The abscissa of the pulse height distribution spectrum represents the pulse height value of the electrical signal, namely, the intensity of light emission of the scintillator. The ordinate represents the frequency of the electrical signal showing each pulse height value.
In a region where the pulse height value of the pulse height distribution spectrum was in the channel about 370, a clear peak due to scintillation light was observed. Thus, the scintillator of the present invention was found to have sufficient light emission intensity.

Example 2

Nd-containing lithium lutetium fluoride was produced in the same manner as in Example 1, except that the proportions of the materials in the mixture were 0.24 g of lithium fluoride, 2.1 g of lutetium fluoride, and 0.0091 g of neodymium fluoride. The resulting crystal was identified in the same manner as in Example 1, showing that the crystal was represented by the chemical formula $LiLu_{1-x}Nd_xF_4$ where x was 0.002.
The light emission characteristics of the scintillator were evaluated in the same manner as in Example 1. The spectrum of light emission obtained is shown in Fig. 1. The scintillator of the present Example was confirmed to cause extremely strong light emission at a wavelength of 183 nm upon incidence of hard X-rays.
The pulse height distribution spectrum of the scintillator under $\alpha$-ray irradiation was measured in the same manner as in Example 1. The resulting pulse height distribution spectrum is shown in Fig. 4. In a region where the pulse height value of the pulse height distribution spectrumwas in the channel about 410, a clear peak ascribed to scintillation light was observed. Thus, the scintillator of the present invention was found to have sufficient light emission intensity.

Example 3

Nd-containing lithium lutetium fluoride was produced in the same manner as in Example 1, except that the proportions of the materials in the mixture were 0.23 g of lithium fluoride, 2.1 g of lutetium fluoride, and 0.018 g of neodymium fluoride. The resulting crystal was identified in the same manner as in Example 1, showing that the crystal was represented by the chemical formula $LiLu_{1-x}Nd_xF_4$ where x was 0.003.
The light emission characteristics of the scintillator were evaluated in the same manner as in Example 1. The spectrum of light emission obtained is shown in Fig. 1. The scintillator of the present Example was confirmed to cause extremely strong light emission at a wavelength of 183 nm upon incidence of hard X-rays.
The pulse height distribution spectrum of the scintillator under $\alpha$-ray irradiation was measured in the same manner as in Example 1. The resulting pulse height distribution spectrum is shown in Fig. 5. In a region where the pulse height value of the pulse height distribution spectrum was in the channel about 480, a clear peak ascribed to scintillation light was observed. Thus, the scintillator of the present invention was found to have sufficient light emission intensity.

Example 4

Nd-containing lithium lutetium fluoride was produced in the same manner as in Example 1, except that the proportions of the materials in the mixture were 0.23 g of lithium fluoride, 2.1 g of lutetium fluoride, and 0.054 g of neodymium fluoride. The resulting crystal was identified in the same manner as in Example 1, showing that the crystal was represented by the chemical formula $LiLu_{1-x}Nd_xF_4$ where x was 0.01.
The light emission characteristics of the scintillator were evaluated in the same manner as in Example 1. The spectrum of light emission obtained is shown in Fig. 1. The scintillator of the present Example was confirmed to cause extremely strong light emission at a wavelength of 183 nm upon incidence of hard X-rays.
The pulse height distribution spectrum of the scintillator under α-ray irradiation was measured in the same manner as in Example 1. The resulting pulse height distribution spectrum is shown in Fig. 6. In a region where the pulse height value of the pulse height distribution spectrumwas in the channel about 360, a clear peak ascribed to scintillation light was observed. Thus, the scintillator of the present invention was found to have sufficient light emission intensity.

Comparative Example 1

The production of lanthanum fluoride containing neodymium as a luminescence center element and the preparation of a scintillator were performed in the same manner as in Example 1, except that the proportions of the materials in the mixture were 2.0 g of lanthanum fluoride and 0.23 mg of neodymium fluoride. The scintillator comprising lanthanum fluoride, which contains neodymium, is a publicly known scintillator.
The light emission characteristics of the scintillator were evaluated in the same manner as in Example 1. The spectrum of light emission obtained is shown in Fig. 1.
The pulse height distribution spectrum of the scintillator under α-ray irradiation was measured in the same manner as in Example 1. The resulting pulse height distribution spectrum is shown in Figs. 3 to 6.
In this pulse height distribution spectrum, the peak pulse height value ascribed to scintillation light was in the channel about 70. Thus, the scintillators of the present invention in Examples 1 to 4 were found to have markedly high light emission intensities as compared with the publicly known scintillator.

Comparative Example 2

The production of lithium barium fluoride containing neodymium as a luminescence center element and the preparation of a scintillator were performed in the same manner as in Example 1, except that the proportions of the materials in the mixture were 0.86 g of barium fluoride, 0.13 g of lithium fluoride and 0.0049 g of neodymium fluoride. The scintillator comprising lithiumbarium fluoride, which contains neodymium, is a publicly known scintillator.
The light emission characteristics of the scintillator were evaluated in the same manner as in Example 1. The spectrum of light emission obtained is shown in Fig. 1.
These results showed that the present invention provided a scintillator having markedly high light emission intensity as compared with the publicly known scintillator.

Comparative Example 3

The production of lithium lutetium fluoride containing no neodymium, namely, one in which $x = 0$, and the preparation of a scintillator were performed in the same manner as in Example 1, except that the proportions of the materials in the mixture were 0.24 g of lithium fluoride and 2.1 g of lutetium fluoride.
The light emission characteristics of the scintillator were evaluated in the same manner as in Example 1. The spectrum of light emission obtained is shown in Fig. 1. It was found that when x was less than 0.00001, light emission was so feeble that the resulting product was unable to withstand use as a scintillator.

Explanations of Letters or Numerals:

| | |
|---|---|
| 1 | After-heater |
| 2 | Heater |
| 3 | Heat insulator |
| 4 | Stage |
| 5 | Crucible |
| 6 | Chamber |
| 7 | High frequency coil |

## Claims

**1.** A scintillator comprising neodymium-containing lithium lutetium fluoride which is represented by the following chemical formula

$$LiLu_{1-x}Nd_xF_4$$

where x denotes a numerical value of 0.00001 to 0.2.

**2.** The scintillator according to claim 1, wherein the neodymium-containing lithium lutetium fluoride is a single crystal.

**3.** The scintillator according to claim 1 or 2, wherein the scintillator is a scintillator for high energy photons.

Fig. 1

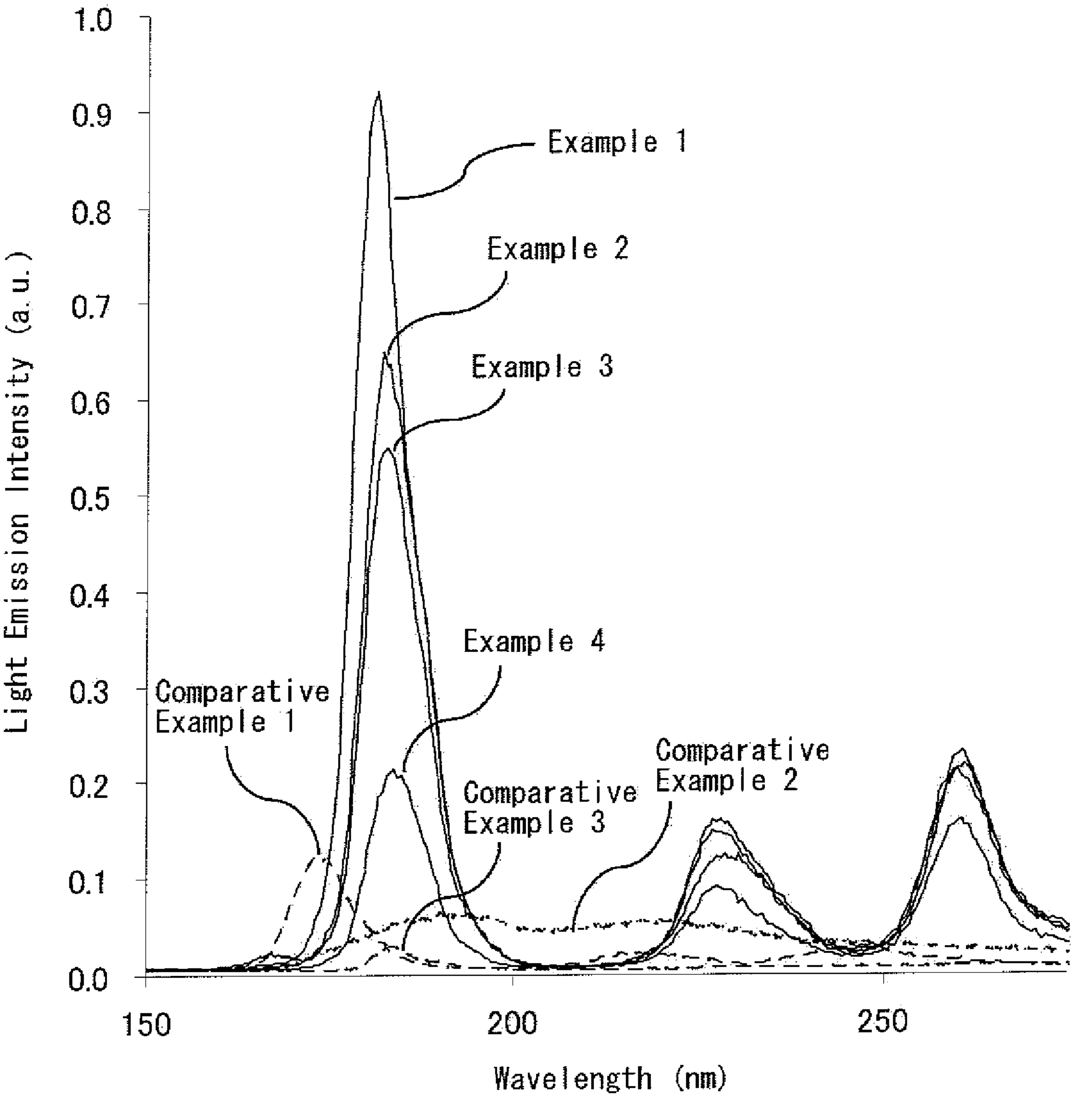
1.0
0.9
0.8
0.7
0.6
0.5
0.4
0.3
0.2
0.1
0.0
Light Emission Intensity (a.u.)
150
200
250
Wavelength (nm)
Example 1
Example 2
Example 3
Example 4
Comparative Example 1
Comparative Example 2
Comparative Example 3

Fig. 2

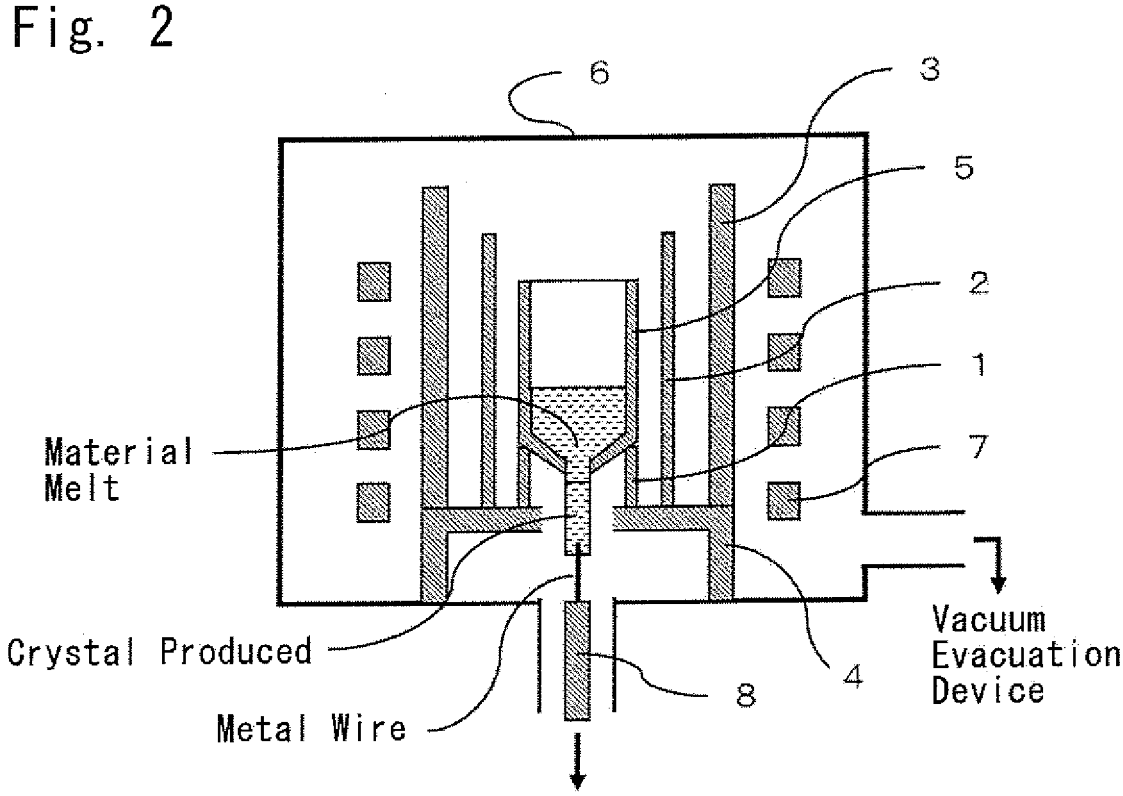
6
3
5
2
1
7
Material
Melt
Crystal Produced
Metal Wire
8
4
Vacuum
Evacuation
Device

Fig. 3

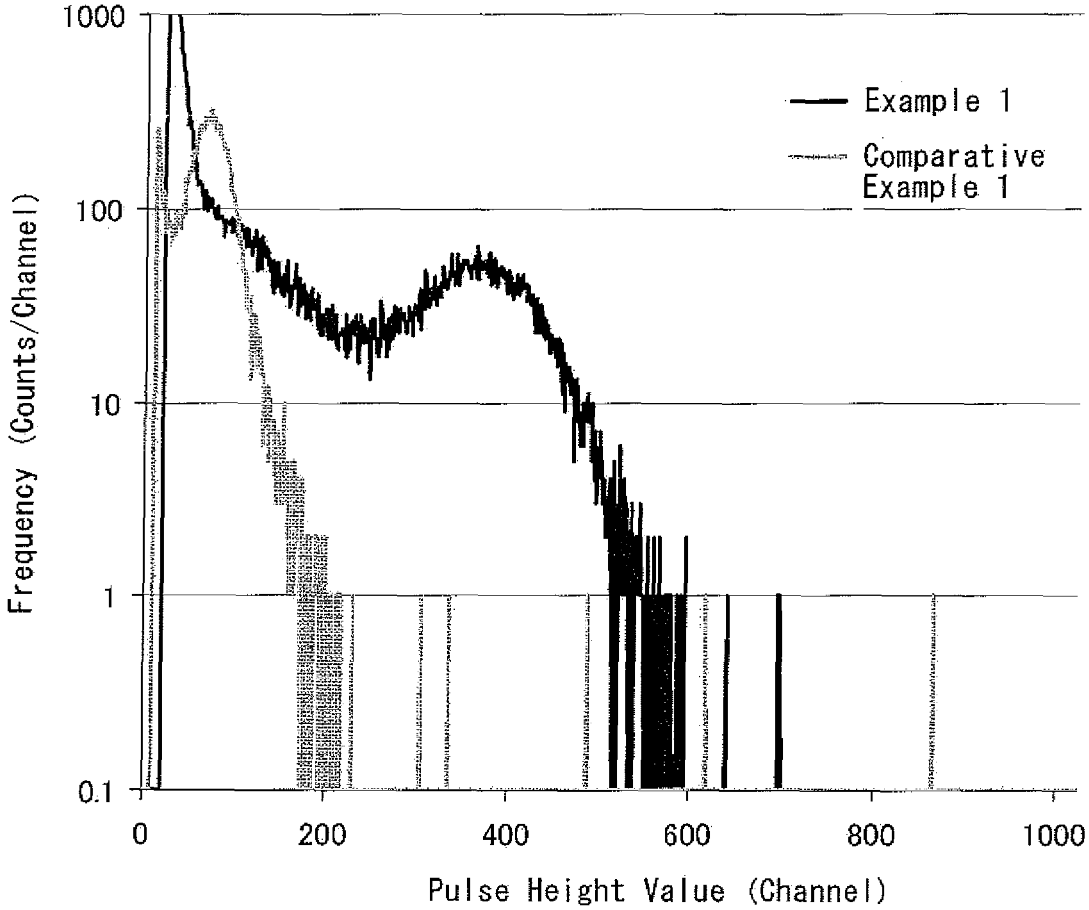
1000
100
10
1
0.1
Frequency (Counts/Channel)
0
200
400
600
800
1000
Pulse Height Value (Channel)
Example 1
Comparative Example 1

Fig. 4

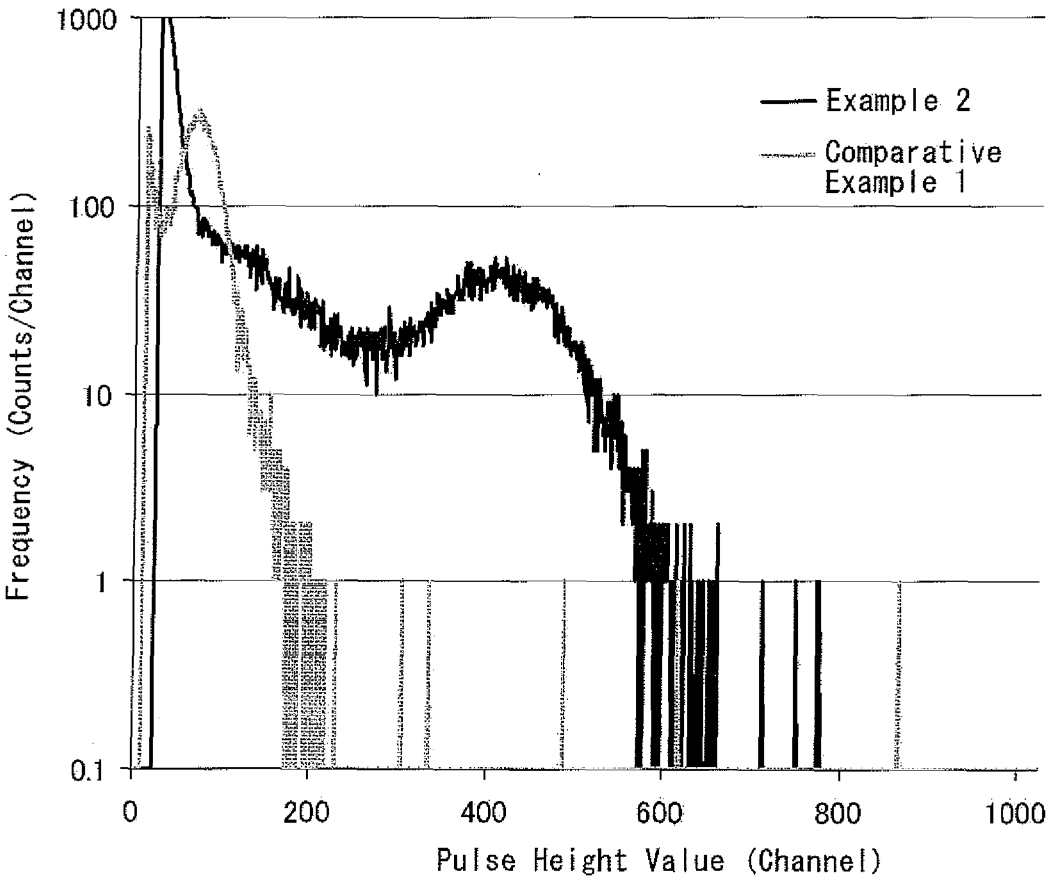
Example 2
Comparative Example 1
1000
100
10
1
0.1
Frequency (Counts/Channel)
0
200
400
600
800
1000
Pulse Height Value (Channel)

Fig. 5

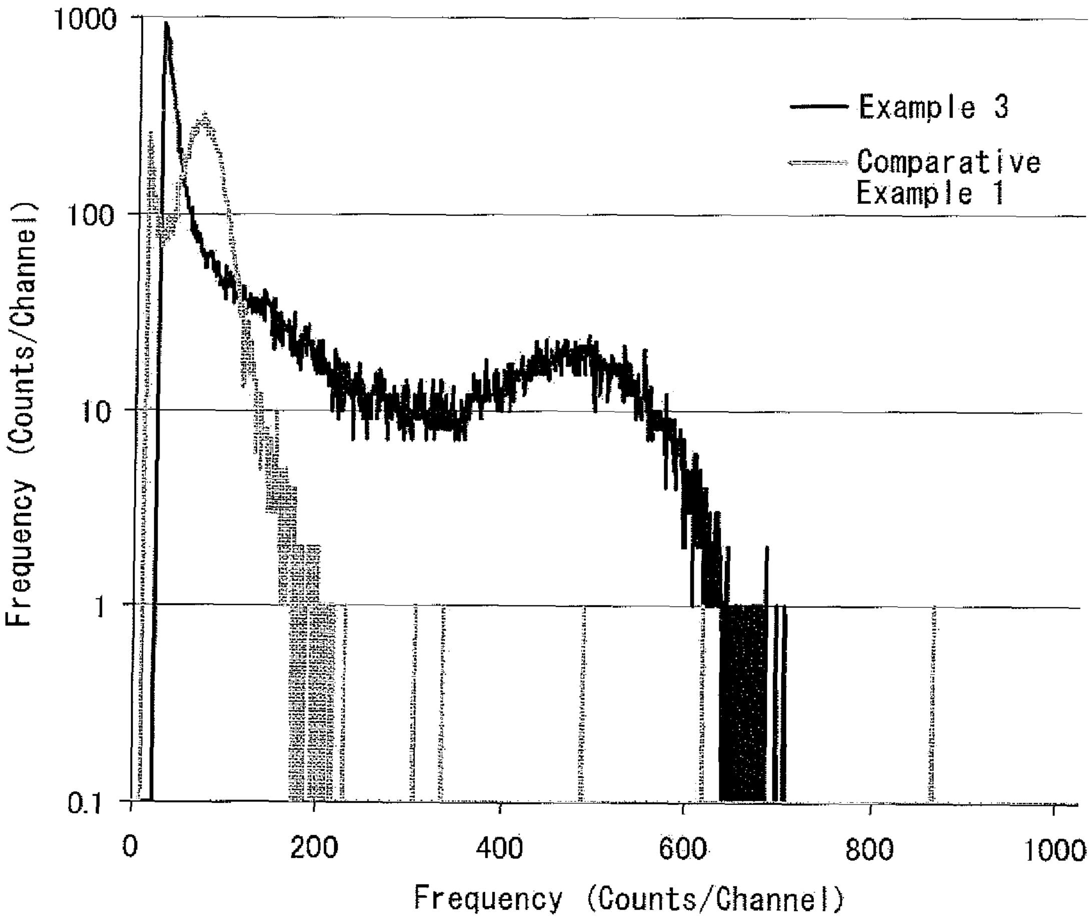
1000
100
10
1
0.1
Frequency (Counts/Channel)
0
200
400
600
800
1000
Frequency (Counts/Channel)
Example 3
Comparative Example 1

Fig. 6

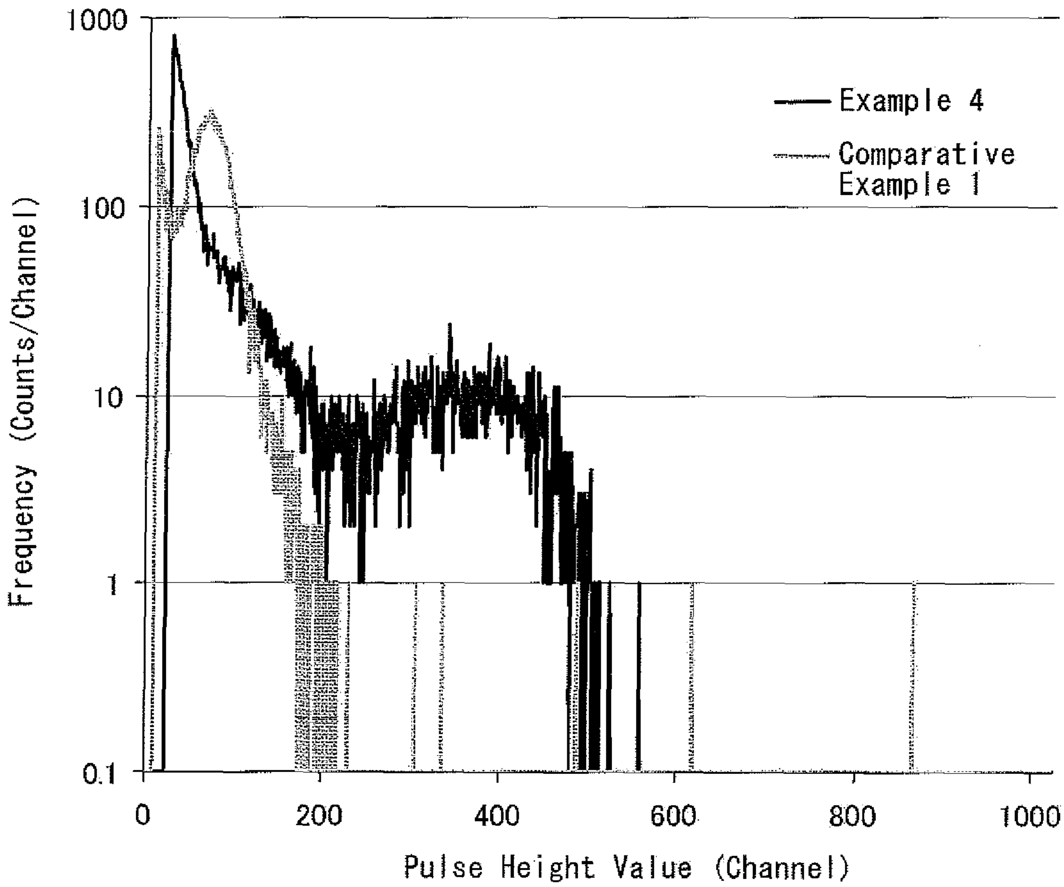
1000
100
10
1
0.1
Frequency (Counts/Channel)
0
200
400
600
800
1000
Pulse Height Value (Channel)
Example 4
Comparative Example 1

Fig. 7

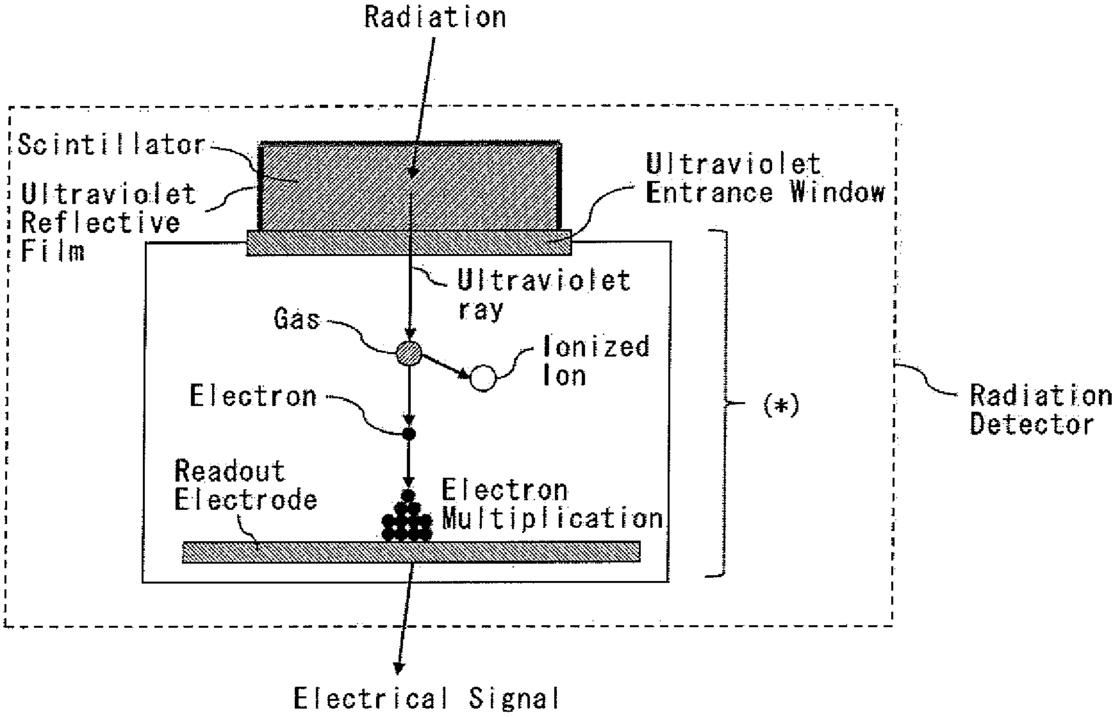


(*): Gas Multiplication Detector

## INTERNATIONAL SEARCH REPORT

International application No.
PCT/JP2010/059263

A. CLASSIFICATION OF SUBJECT MATTER
*C09K11/85*(2006.01)i, *C09K11/00*(2006.01)i, *G01T1/20*(2006.01)i

According to International Patent Classification (IPC) or to both national classification and IPC

B. FIELDS SEARCHED

Minimum documentation searched (classification system followed by classification symbols)
C09K11/00-11/89, G01T1/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | WO 2008/093553 A1 (Konica Minolta Medical & Graphic, Inc.), 07 August 2008 (07.08.2008), paragraphs [0045] to [0064]; claim 9 (Family: none) | 1-3 |
| A | JP 2007-532746 A (Saint-Gobain Christaux Et Detecteurs), 15 November 2007 (15.11.2007), claims; paragraphs [0017] to [0028] & US 2007/0241284 A1 & EP 1738199 A & WO 2005/103760 A1 & DE 602005004395 T2 & FR 2869115 A1 & CA 2562646 A1 & AT 384271 T & EA 9229 B1 | 1-3 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 June, 2010 (19.06.10) | 29 June, 2010 (29.06.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No.
PCT/JP2010/059263

C (Continuation). DOCUMENTS CONSIDERED TO BE RELEVANT

| Category* | Citation of document, with indication, where appropriate, of the relevant passages | Relevant to claim No. |
|---|---|---|
| A | Ranieri, I.M., Growth of $LiY_{1-x}Lu_xF_4$ crystals under $CF_4$ atmosphere, Journal of alloys and compounds, 2002, vol.344, p.203-206 | 1-3 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008202977 A


### Non-patent literature cited in the description


- **Semashko, V.V. et al.** Regarding the possibilities of upconversion UV and VUV lasers based on 5d-4f transitions of rare-earth ions in wide-bandgap dielectric crystals. *Proceedings of SPIE-The International Society for Optical Engineering,* 2000, vol. 4061, 306-316
- **P. Schotanus et al.** *Nuclear Instruments and Methods in Physics Research,* 1988, vol. A272, 913-916